# EUROPÄISCHE PATENTSCHRIFT

(11) **EP 1 197 776 B1**
(45) Veröffentlichungstag und Bekanntmachung des Hinweises auf die Patenterteilung: **06.10.2004**
(21) Anmeldenummer: 01118865.3
(22) Anmeldetag: 16.08.2001
(51) Int. Cl.: G02B 7/18

(54) **Vorrichtung zum Temperaturausgleich für thermisch belastete Körper mit niederer Wärmeleitfähigkeit, insbesondere für Träger reflektierender Schichten oder Substrate in der Optik**
System for temperature compensation of thermally loaded bodies having a low heat conductivity, especially of supports for reflective layers or substrates in optics
Système de compensation de température pour des corps sous charge thermique à conductibilité thermique basse, en particulier pour des supports des couches réfléchissantes ou des substrats dans l'optique

(30) Priorität: 11.10.2000 DE 10050125
(43) Veröffentlichungstag der Anmeldung: 17.04.2002
(73) Patentinhaber: Carl Zeiss SMT AG, 73447 Oberkochen (DE)
(72) Erfinder: Dieker, Thomas, 89081 Ulm (DE)
(74) Vertreter: Lorenz, Werner, Dr.-Ing.

(56) Entgegenhaltungen:
- DE-A- 4 007 622
- DE-U- 9 321 453
- US-A- 3 836 236
- US-A- 4 832 475

## Beschreibung

Die Erfindung betrifft eine Vorrichtung zum Ausgleich von Temperaturdifferenzen in thermisch belasteten Körpern, insbesondere für Träger reflektierender Schichten oder Substrate in der Optik nach der im Oberbegriff von Anspruch 1 näher definierten Art. Die Erfindung betrifft insbesondere Vorrichtungen für Spiegelträger, die in Projektionsobjektiven für die Halbleiter-Lithographie eingesetzt werden.

Wärmeverteilungsvorrichtungen sind in der Halbleiter-Lithographie allgemein bekannt. So beschreiben z.B. die US 5,220,171 und US 5,413,167 Wärmeverteilungsvorrichtungen zur Kühlung von Wafern unter Verwendung einer in Kanälen geführten Flüssigkeit als Wärme transportierendes Medium.

Auch die US-PS 5,313,333 befaßt sich mit Einrichtungen zur Kompensation von Temperaturabweichungen in einer optischen Baugruppe.

Die japanische Veröffentlichung JP 83 13 818 offenbart einen Spiegel mit einer Deckplatte, die eine Spiegelschicht aufweist, und einer darunter angeordneten Unterplatte, die auf Abstand dazu liegt, wobei beide Teile durch Stege und dazwischen liegende Kammern miteinander verbunden werden.

Ein Spiegelträger in einem Projektionsobjektiv für die Halbleiter-Lithographie wird durch absorbierte Nutzstrahlenergie erwärmt. Daraus ergeben sich zwei voneinander zu unterscheidende Temperaturprobleme:

Das eine Problem besteht in einer zu starken Erhöhung der mittleren Substrattemperatur. Dadurch kann es zu Veränderungen im Gefüge von Substrat- und Schichtmaterialien kommen, die sich nachteilig auf die Eigenschaften der optischen Oberfläche auswirken.

Das andere Problem liegt in einer inhomogenen Temperaturverteilung innerhalb des Spiegelsubstrats. Aufgrund der Thermaldehnung hat eine inhomogene Temperaturverteilung eine dazu in etwa analoge Dehnungsverteilung zur Folge, die das Spiegelsubstrat und damit die optische Oberfläche deformiert.

Für beide Thermalprobleme, insbesondere aber für das der inhomogenen Temperaturverteilung sollte eine Lösung gefunden werden. Zum besseren Verständnis der besonderen Wirkungsweise ist im folgenden das Problem der inhomogenen Temperaturverteilung noch näher erläutert:

Die inhomogene Temperaturverteilung innerhalb des Substrats hat im wesentlichen folgende zwei Ursachen:

Während der Wärmeeintrag fast ausschließlich über die optische Oberfläche erfolgt, vollzieht sich die Abgabe der Wärme hauptsächlich durch Abstrahlung an Spiegelrand und Spiegelrückseite und zum Teil durch Wärmeleitung über die Fassung. Da die Stellen des Wärmeeintrags damit woanders liegen als die des Wärmeaustrags, kommt es aufgrund des thermischen Widerstands des Substratmaterials zur Ausbildung von Temperaturgradienten.

Die zweite Ursache ist die in aller Regel inhomogene Ausleuchtung der optischen Oberfläche, denn zum einen beansprucht der Strahlbereich nicht die gesamte optische Oberfläche und zum anderen bedingt das mit der Projektionsoptik abgebildete Schaltkreismuster eine inhomogene Intensitätsverteilung innerhalb des Strahlbereichs. Stark bestrahlte Bereiche der optischen Oberfläche erwärmen sich dann stärker als schwach bestrahlte. Möchte man das Problem der durch eine inhomogene Temperaturverteilung verursachten Substratdeformation lösen, so bietet sich an, ein Substratmaterial zu verwenden, dessen thermischer Ausdehnungskoeffizient sehr niedrig ist. Dieser Weg wird in der Präzisionsoptik mit der Wahl von Trägermaterialien wie Quarz, Zerodur oder ULE oftmals beschritten und führt zu einer für viele Anwendungen hinreichend niedrigen Substratdeformation. Nachteilig an den genannten Materialien ist jedoch ihre im Vergleich zu metallischen Werkstoffen viel niedrigere Wärmeleitfähigkeit, die zu verhältnismäßig großen Temperaturdifferenzen innerhalb des thermisch belasteten Spiegelträgers führt und den deformationsmindernden Effekt des niedrigen thermischen Ausdehnungskoeffizienten zum Teil wieder zunichte macht. Diese Tatsache wirkt sich insbesondere bei Spiegelträgern in Halbleiter-Lithographieobjektiven für die 13nm-Technologie (EUVL) sehr nachteilig aus, da wegen des hohen Absorptionsgrades einer einzelnen optischen Oberfläche von etwa 40 % im 13nm-Band der Wärmestrom im Spiegelträger sehr groß wird und damit auch große Temperaturdifferenzen im Substrat auftreten. Gleichzeitig sind die Anforderungen an die Oberflächenformgenauigkeit bei einem Spiegelsystem, wie es ein EUVL-Objektiv darstellt, erheblich größer als bei Linsenoptiken, wie sie zur Zeit in der Halbleiter-Lithographie hauptsächlich eingesetzt werden. Aus DE 932 145 U und aus DE 4 007 622 sind Vorrichtungen zum Temperaturaugsleich von Spiegeln bekannt, bei denen eine Kühlflüssigkeit mit dem Spiegel in kontakt steht.

Im nächstliegenden Stand der Technik, US-A-3 836 236, erfolgt eine Trennung zwischen einer mechanischen Kopplung und einer thermischen Kopplung gegenüber dem thermisch belasteten Körper. Zwischen der Wärme verteilenden und Wärme abführenden Wärmeverteilungseinrichtung und dem thermisch belasteten Körper, wird in einen entsprechend geschaffenen Spalt oder in einer Zwischenspalte ein Koppelfluid eingebracht. Das Koppelfluid sorgt für eine thermische Kopplung zu der Wärmeverteilungseinrichtung, entkoppelt aber diese gleichzeitig mechanisch von dem thermisch belasteten Körper. Auf diese Weise werden Verformungen der Wärmeverteilungseinrichtung nicht auf den thermisch belasteten Körper, z.B. ein Spiegelsubstrat bzw. einen Spiegelträger, übertragen.

Der vorliegenden Erfindung liegt die Aufgabe zugrunde einen deformierenden Einfluß des Mediendrucks des Koppelfluids auf den thermisch belasteten Körper auszuschließen. Erfindungsgemäß wird diese Aufgabe durch die im kennzeichnenden Teil von Anspruch 1 genannten Merkmale gelöst. Die Einrichtung kann in Form eines Steigrohres oder eines elastischen Gefäßes z.B. einem Metallmembranfaltenbalg ausgeführt sein. Bevorzugt wird die Ausführung mit einem aus einem Metallmembranfaltenbalg gebildeten elastischen Gefäß, da hiermit die Möglichkeit besteht, das Koppelfluid gegenüber der Substratumgebung abzudichten und so ein Auslaufen oder Ausgasungen des Koppelfluids zu verhinderen.

Als Wärmeverteilungskörper kann dabei ein massiver Festkörper aus einem Material hoher spezifischer thermischer Leitfähigkeit, wie z.B. Cu, Al, Ag etc. eingesetzt werden. Eine andere Ausführungsform eines Wärmeverteilungskörpers besteht aus einem mit Kapillaren durchzogenen dünnwandigen Festkörper, z.B. einem Rohr, dessen Kapillare von einem zweiten Fluid durchströmt werden. Hier erfolgt die Wärmeverteilung durch Mitführung der Wärme mit dem strömenden Fluid.

Das Koppelfluid, das den Spalt zwischen dem Substrat, also dem thermisch belasteten Körper, und dem Wärmeverteilungskörper ausfüllt, kann eine Flüssigkeit, ein Gas oder auch ein Stoff mit hinreichend niedriger Viskosität sein. Bevorzugt werden Flüssigkeiten mit guter thermischer Leitfähigkeit, wie z.B. Wasser, Quecksilber oder bei Raumtemperatur flüssige Metalllegierungen.

Das Koppelfluid, das den Spalt zwischen dem thermisch belasteten Körper und dem Wärmeverteilungskörper ausfüllt, führt keine Bewegung aus, strömt also nicht. Dadurch sind Druckunterschiede innerhalb des Spaltvolumens aufgrund von Strömungsdruckabfällen ausgeschlossen.

In einer vorteilhaften Weiterbildung der Erfindung ist die Wärmeverteilungseinrichtung mit einer oder mehreren Temperiereinrichtungen verbunden. Mit dieser Weiterbildung ist es möglich, die mittlere Temperatur des thermisch belasteten Körpers zu reduzieren und zu stabilisieren. Als Temperiereinrichtungen können beispielsweise Peltierelemente verwendet werden, deren kühlende Seite direkt mit dem Wärmeverteilungskörper der Wärmeverteilungseinrichtung verbunden ist und dessen wärmere Seite die vom thermisch belasteten Körper aufgenommene Wärme sowie die beim Betrieb des Peltierelements anfallende Verlustenergie durch Wärmestrahlung an die Umgebung abgibt. In einer anderen Ausführung wird der Wärmeverteilungskörper von einer Kühlflüssigkeit durchströmt, die aus dem Wärmeverteilungskörper herausgeführt wird und über eine außerhalb der Wärmeverteilungseinrichtung liegende Temperiervorrichtung gekühlt wird.

Weitere vorteilhafte Weiterbildungen und Ausgestaltungen der Erfindung ergeben sich aus den Unteransprüchen und aus den nachfolgend anhand der Zeichnung prinzipmäßig beschriebenen Ausführungsbeispielen.

Es zeigt:
- Figur 1: einen Schnitt durch eine Ausführungsform, bei welcher der Wärmeverteilungskörper der Wärmeverteilungseinrichtung an eine Außenseite des thermisch belasteten Körpers adaptiert ist;
- Figur 2: einen Schnitt durch eine Ausführungsform, bei welcher der Wärmeverteilungskörper in den thermisch belasteten Körper eingebettet ist;
- Figur 3: einen Schnitt durch eine Ausführungsform, bei welcher der Wärmeverteilungskörper in den thermisch belasteten Körper eingebettet ist und durch eine außen liegende Tragstruktur gehalten wird;
- Figur 4: einen Schnitt durch eine Ausführungsform, bei welcher der Wärmeverteilungskörper aus einer von einer Flüssigkeit durchströmten Rohrstruktur gebildet wird;
- Figur 5: einen Schnitt nach der Linie V-V der Figur 4;
- Figur 6: eine vergrößerte Darstellung des Ausschnitts X in der Figur 5;
- Figur 7: einen Schnitt durch eine Ausführungsform, bei welcher der Wärmeverteilungskörper mit einer Vielzahl thermisch gut leitfähiger Finger versehen ist, die durch Bohrungen bis nahe an die optische Oberfläche reichen;
- Figur 8: einen Schnitt durch eine Ausführungsform, bei welcher an den Wärmeverteilungskörper Peltierelemente als Teil einer Temperiereinrichtung adaptiert sind;
- Figur 9: eine vergrößerte Darstellung des Ausschnittes Y in der Figur 8; und
- Figur 10: einen Schnitt durch eine Ausführungsform, bei welcher der Wärmeverteilungskörper von einem Fluid durchströmt wird, welches aus der Wärmeverteilungseinrichtung herausgeführt und in einer außerhalb liegenden Temperiervorrichtung temperiert wird.

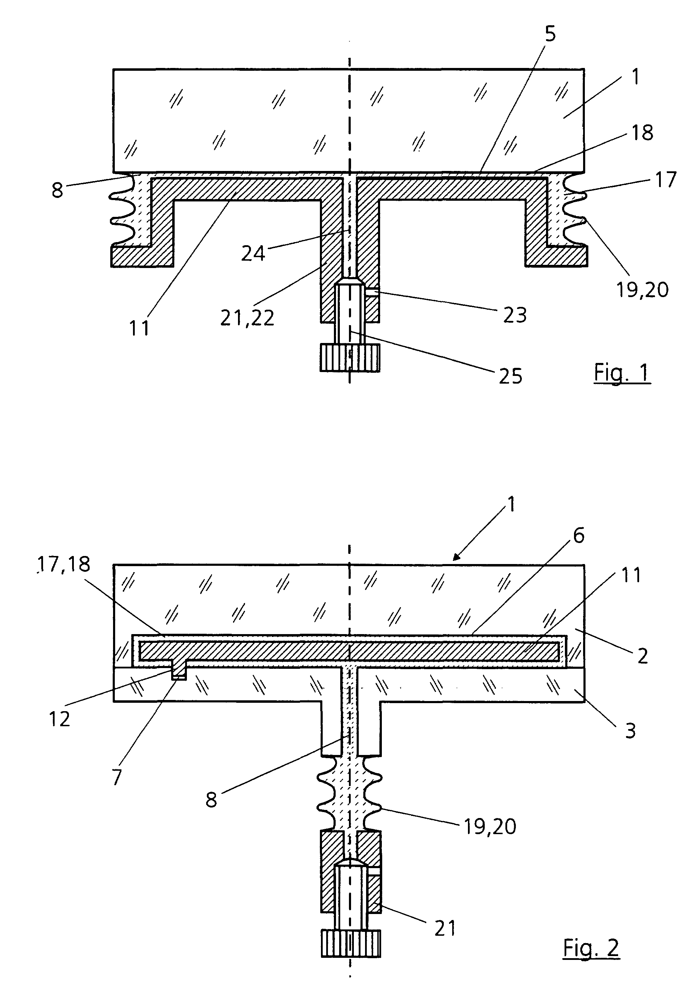

Figur 1 zeigt eine Vorrichtung mit einer Wärmeverteilungseinrichtung, die an eine äußere Oberfläche 5 eines thermisch belasteten Körpers 1 adaptiert ist. Die Wärmeverteilungseinrichtung besteht aus einem Wärmeverteilungskörper 11, einem Koppelfluid 17, einer Druckausgleichseinrichtung 19 und einer Befüllungseinrichtung 21. Der Wärmeverteilungskörper 11 ist als massiver Körper aus einem Material hoher spezifischer Wärmeleitfähigkeit, wie z.B. Cu, Al, Ag, Al₂O₃ oder SiC ausgeführt, und ist so gestaltet und angeordnet, daß zwischen dem thermisch belasteten Körper 1 und dem Wärmeverteilungskörper 11 ein enger Spalt 18 verbleibt, der mit dem Koppelfluid 17 ausgefüllt ist. Das Fluid, z.B. He oder ein anderes Edelgas bzw. H₂O, Hg oder eine bei Raumtemperatur flüssige Metallegierung, sorgt für einen guten Wärmeübergang zwischen der äußeren Oberfläche des thermisch belasteten Körpers und dem Wärmeverteilungskörper, während es gleichzeitig die Übertragung von Deformationen des Wärmeverteilungskörpers auf den thermisch belasteten Körper verhindert.

Die Druckausgleichseinrichtung 19 ist als Metallmembranfaltenbalg 20 ausgeführt, der zugleich die Umgrenzung der thermischen Koppelfläche bildet und den thermisch belasteten Körper 1 und den Wärmeverteilungskörper 11 miteinander verbindet. Die Druckausgleichseinrichtung 19 sorgt für einen Druckausgleich zwischen der äußeren Umgebung 9 und dem Koppelfluid 17, so daß an allen Oberflächen des thermisch belasteten Körpers nahezu der gleiche Flächendruck wirkt. Des weiteren verhindert die Druckausgleichseinrichtung 19 eine Veränderung des Mediendrucks des Koppelfluids 17 bei Formänderungen des Wärmeverteilungskörpers 11. Der Metallmembranfaltenbalg 20 dichtet zudem das Koppelfluid 17 gegen die äußere Umgebung 9 ab und dient als Befestigungselement niedriger Steifigkeit, mit dem die Wärmeverteilungseinrichtung an den thermisch belasteten Körper 1 befestigt ist.

Zum Befüllen des Spaltes 18 mit dem Koppelfluid 17 ist die Wärmeverteilungseinrichtung mit einer am Wärmeverteilungskörper 11 angebrachten Befüllungseinrichtung 21 versehen. Die Befüllungseinrichtung 21 hat die Funktion einer verschließbaren Verbindung zwischen dem Spaltvolumen und der äußeren Umgebung 9. Die Befüllungseinrichtung besteht aus einem Gehäuse 22, das mit einer Befüllungsöffnung bzw. Einlaßöffnung 23 nach außen und einem Verbindungskanal 24 zum Spalt 18 ausgestattet ist und einer Ventilschraube 25.

Figur 2 zeigt eine Vorrichtung mit einer Wärmeverteilungseinrichtung, bei welcher der Wärmeverteilungskörper 11 an eine innere Oberfläche 6 des thermisch belasteten Körpers 1 adaptiert ist. Der thermisch belastete Körper 1 besteht aus zwei Teilen, einem Oberteil 2 und einem Unterteil 3, wobei diese so gestaltet sind, daß nach dem Zusammenfügen von Ober- und Unterteil ein innerhalb des thermisch belasteten Körpers 1 befindliches Volumen vorliegt. Bevor Ober- und Unterteil 2 und 3 z.B. durch Kleben miteinander verbunden werden, wird der Wärmeverteilungskörper 11 in das entstehende innere Volumen eingelegt. Nach dem Zusammenfügen besteht zwischen innerem Volumen und äußerer Umgebung 9 nur noch über einen Volumenausgleichskanal 8 eine Verbindung, ansonsten ist das innere Volumen durch die Fügefläche zwischen Ober- und Unterteil 2 und 3 gegenüber der äußeren Umgebung 9 abgedichtet.

Wie in der Ausführung nach Figur 1 ist die Wärmeverteilungseinrichtung aus einem Wärmeverteilungskörper 11, einem Koppelfluid 17, einer Druckausgleichseinrichtung 19 und einer Befüllungseinrichtung 21 aufgebaut. Der Wärmeverteilungskörper 11 ist als massiver Körper aus einem Material hoher spezifischer Wärmeleitfähigkeit ausgeführt und so gestaltet und angeordnet, daß zwischen thermisch belastetem Körper und Wärmeverteilungskörper ein enger Spalt 18 verbleibt, der mit einem Koppelfluid 17 zur thermischen Koppelung von thermisch belastetem Körper und Wärmeverteilungskörper 11 ausgefüllt ist. Zur Befüllung des Spaltvolumens mit dem Koppelfluid 17 und zum Ausgleich von Volumenänderungen des vom Koppelfluid 17 ausgefüllten Spaltes 18 führt der Volumenausgleichskanal 8 vom inneren Volumen in die Druckausgleichseinrichtung 19, die durch den Metallmembranfaltenbalg 20 gebildet wird und mit dem Unterteil 3 des thermisch belasteten Körpers 1 verbunden ist. An die Druckausgleichseinrichtung 19 schließt sich die Befüllungseinrichtung 21 zum Befüllen des Systems mit dem Koppelfluid 17 an.

Da der Wärmeverteilungskörper 11 mit seiner Gewichtskraft auf dem Unterteil 3 des thermisch belasteten Körpers 1 aufliegt, ist es vorteilhaft, ortsfeste Auflagestellen zu schaffen, so daß der durch die Auflagekräfte verursachte Deformationszustand des thermisch belasteten Körpers 1 unverändert bleibt. Hierzu kann der Wärmeverteilungskörper 11 mit drei Abstützzapfen 12 versehen sein, die in Zentrierbohrungen 7 des Unterteils 3 des thermisch belasteten Körpers 1 hineinreichen. Daraus ergibt sich eine gegen Verdrehungen und Verschiebungen gesicherte statisch bestimmte Auflage des Wärmeverteilungskörpers 11.

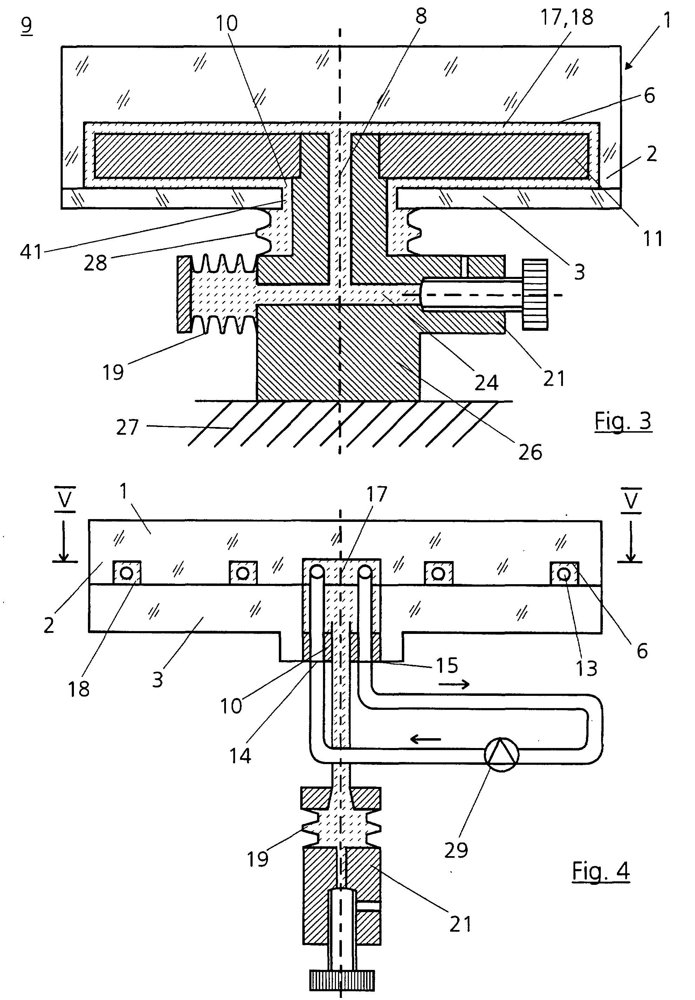

Figur 3 zeigt eine Vorrichtung mit einer Wärmeverteilungseinrichtung entsprechend der Ausführung nach Figur 2 mit dem Unterschied, daß der Wärmeverteilungskörper 11 anstatt auf dem Unterteil 3 des thermisch belasteten Körpers 1 aufzuliegen, über einen ebenfalls zur Wärmeverteilungseinrichtung gehörenden Trägerkörper 26 mit einer äußeren Tragstruktur 27 verbunden und damit weitgehend unabhängig vom thermisch belasteten Körper 1 gehaltert ist. Die Druckausgleichseinrichtung 19 ist im Unterschied zur Ausführung nach Figur 2 an den Trägerkörper 26 adaptiert und über einen durch den Trägerkörper führenden Volumenausgleichskanal 8 mit dem fluidgefüllten Spalt 18 verbunden.

Die Befüllungseinrichtung 21 ist im Unterschied zur Ausführung nach Figur 2 ebenfalls an den Trägerkörper 26 adaptiert und über den durch den Trägerkörper 26 führenden Befüllungskanal bzw. Verbindungskanal 24 mit dem Spalt 18 verbunden. Der Trägerkörper 26 ragt von außen durch eine Öffnung 10 im Unterteil 3 des thermisch belasteten Körpers 1 in das innere Volumen des thermisch belasteten Körpers hinein und ist dort fest mit dem Wärmeverteilungskörper 11 verbunden.

Zwischen dem thermisch belasteten Körper 1 und dem Trägerkörper 26 gibt es keine direkte Verbindung, vielmehr sind beide Teile durch einen fluidgefüllten Spalt 41 voneinander getrennt. Das im Spaltvolumen befindliche Fluid wird mit Hilfe eines dichtenden elastischen Elements 28 geringer Steifigkeit, z.B. einem Metallmembranfaltenbalg, das zwischen Unterteil 3 des thermisch belasteten Körpers und Trägerkörper 26 angeordnet ist, gegenüber der äußeren Umgebung 9 abgedichtet. Durch die geringe Steifigkeit des dichtenden elastischen Elements 28 sind die über dieses Element übertragenen Kräfte bei Relativbewegungen zwischen Trägerkörper 26 und thermisch belasteten Körper 1 so gering, daß dadurch keine nennenswerte Deformation der optischen Oberfläche verursacht wird.

Die Figuren 4, 5 und 6 zeigen eine Vorrichtung mit einer Wärmeverteilungseinrichtung entsprechend der Ausführung nach Figur 2 mit dem Unterschied, daß der Wärmeverteilungskörper 11 als dünnwandiger Hohlkörper 13, z.B. einem Rohr, ausgeführt ist, welcher von einem zweiten Fluid 30 durchströmt wird, um durch den derart erfolgenden Stofftransport durch den Wärmeverteilungskörper auch die vom Wärmeverteilungskörper 11 aufgenommene Wärme zu transportieren und dadurch gleichmäßig zu verteilen. Ebenfalls im Unterschied zur Ausführung nach Figur 2 wird der Wärmeverteilungskörper aus dem inneren Volumen des thermisch belasteten Körpers 1 herausgeführt, um zwischen einer am Wärmeverteilungskörper angebrachten Einlaßöffnung 14 und einer ebenfalls am Wärmeverteilungskörper angebrachten Auslaßöffnung 15 für das strömende Fluid 30 eine Umwälzeinrichtung 29 in Form einer Medienpumpe anschließen zu können, wobei diese Umwälzeinrichtung 29 Teil der Wärmeverteilungseinrichtung ist. Zwischen den beiden Fluiden 17 und 30 der Wärmeverteilungseinrichtung ist streng zu unterscheiden, denn während das erste Fluid 17 dem Wärmeübergang zwischen thermisch belastetem Körper 1 und Wärmeverteilungskörper 11 bzw. 13 dient und überall den gleichen Mediendruck aufweist, dient das zweite Fluid 30 der Wärmeverteilung innerhalb des Wärmeverteilungskörpers und weist wegen des Strömungsdruckabfalls örtlich unterschiedliche Mediendrücke auf. Die Halterung des Wärmeverteilungskörpers erfolgt über eine feste Verbindung zwischen Wärmeverteilungskörper und thermisch belastetem Körper 1 im Bereich der Öffnung 10 im Unterteil des thermisch belasteten Körpers, aus welcher der Wärmeverteilungskörper aus dem inneren Volumen herausgeführt wird.

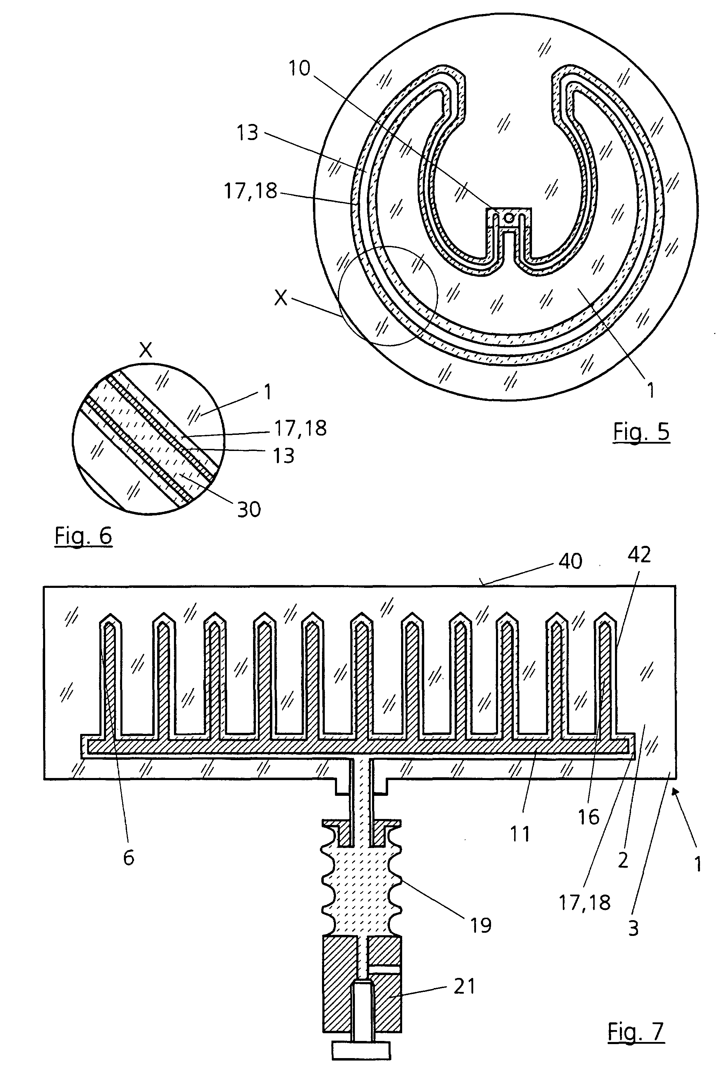

Figur 7 zeigt eine Vorrichtung mit einer Wärmeverteilungseinrichtung entsprechend der Ausführung nach Figur 2 mit dem Unterschied, daß der Wärmeverteilungskörper 11 mit einer Vielzahl von thermisch gut leitfähigen Fingern 16 versehen ist, die durch entsprechende Bohrungen 42 im Oberteil 2 des thermisch belasteten Körpers 1 bis nahe an die optische Oberfläche 40 heranreichen. Durch die konstruktive Variante können insbesondere Temperaturgradienten reduziert werden, die senkrecht zur optischen Oberfläche gerichtet sind, die also quasi von oben nach unten verlaufen.

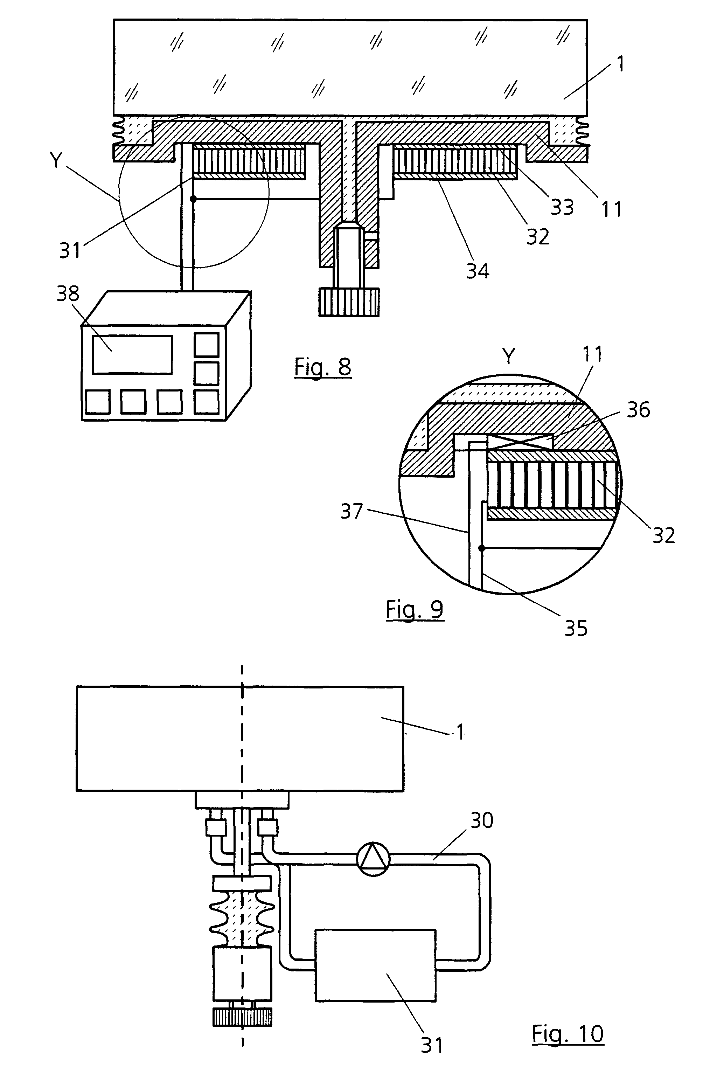

Die Figuren 8 und 9 zeigen eine Weiterbildung einer Wärmeverteilungseinrichtung entsprechend der Ausführung nach Figur 1. Die Wärmeverteilungseinrichtung ist dabei zusätzlich mit einer Temperiereinrichtung 31, bestehend aus ein oder mehreren Peltierelementen 32, einem Temperatursensor 36 und einem Temperaturregelgerät 38 ausgestattet. Diese Weiterbildung ermöglicht es, die mittlere Temperatur des thermisch belasteten Körpers 1 weitgehend unabhängig von der Höhe der pro Zeiteinheit absorbierten Nutzstrahlenergie konstant zu halten. Da zur Stabilisierung der Temperatur meist Wärme aus dem thermisch belasteten Körper 1 herausgeführt werden muß, sind die Peltierelemente 32 mit ihrer kühleren Seite 33 flächig mit dem Wärmeverteilungskörper 11 verbunden, während die wärmere Seite 34 frei bleibt und so angeordnet ist, daß die von dieser Fläche abgegebene Wärme in Form von Strahlung an die umliegende Strukturumgebung abgegeben werden kann. Zur Temperaturbestimmung ist der Temperatursensor 36 in den Wärmeverteilungskörper 11 eingebettet. Elektrische Zuleitungen 35, 37 der Peltierelemente 32 und des Temperatursensors 36 führen zu dem Temperaturregelgerät 38, so daß ein geschlossener Regelkreis entsteht.

Figur 10 zeigt eine Vorrichtung mit einer Wärmeverteilungseinrichtung entsprechend der Ausführung nach den Figuren 4, 5 und 6, wobei als Weiterbildung eine Temperiereinrichtung 31 in einen Kreislauf 39 des strömenden Fluids 30 eingebracht ist, so daß mittels der Temperiereinrichtung 31 die Temperatur des strömenden Fluids unabhängig von der pro Zeiteinheit vom thermisch belasteten Körper 1 absorbierten Nutzstrahlenergie geführt werden kann.

### Legende zu den Bildern:

- 1: thermisch belasteter Körper
- 2: Oberteil des thermisch belasteten Körpers
- 3: Unterteil des thermisch belasteten Körpers
- 4: Oberfläche des thermisch belasteten Körpers
- 5: äußere Oberfläche des thermisch belasteten Körpers
- 6: innere Oberfläche des thermisch belasteten Körpers
- 7: Zentrierbohrung
- 8: Volumenausgleichskanal bzw. Verbindung zwischen Spaltvolumen und Druckausgleichseinrichtung
- 9: äußere Umgebung
- 10: Öffnung im Unterteil des thermisch belasteten Körpers
- 11: Wärmeverteilungskörper
- 12: Abstützzapfen
- 13: als Hohlkörper ausgeführter Wärmeverteilungskörper
- 14: Einlaßöffnung für strömendes Fluid
- 15: Auslaßöffnung für strömendes Fluid
- 16: fingerartiger Fortsatz des Wärmeverteilungskörpers
- 17: Koppelfluid
- 18: Spalt bzw. Spaltvolumen
- 19: Druckausgleichseinrichtung
- 20: Metallmembranfaltenbalg
- 21: Befüllungseinrichtung
- 22: Gehäuse der Befüllungseinrichtung
- 23: Einlaßöffnung
- 24: Verbindungskanal zwischen Befüllungseinrichtung und Spaltvolumen
- 25: Ventilschraube
- 26: Trägerkörper
- 27: äußere Tragstruktur
- 28: dichtende elastische Verbindung geringer Steifigkeit
- 29: Umwälzeinrichtung
- 30: strömendes Fluid
- 31: Temperiereinrichtung
- 32: Peltierelement / Wärmetauschelement
- 33: kühle Seite des Peltierelements
- 34: warme Seite des Peltierelements
- 35: elektrische Zuleitung des Peltierelements
- 36: Temperatursensor
- 37: elektrische Zuleitung des Temperatursensors
- 38: Temperaturregelgerät
- 39: Kreislauf des strömenden Fluids
- 40: optische Oberfläche eines Spiegelträgers als thermisch belasteten Körper
- 41: fluidgefüllter Spalt zwischen thermisch belastetem Körper und Trägerkörper
- 42: Bohrung im Oberteil des thermisch belasteten Körpers

## Patentansprüche

1. Vorrichtung zum Temperaturausgleich für thermisch belastete Körper aus Materialien niedriger spezifischer Wärmeleitfähigkeit, insbesondere für Träger reflektierender Schichten oder Substrate in der Optik, wie z.B. in Projektionsobjektiven für die Halbleiter-Lithographie, wobei eine Wärmeverteilungseinrichtung mit ein oder mehreren Wärmeverteilungskörpern (11,13) so an Oberflächen (5,6) des thermisch belasteten Körpers (1) adaptiert ist, dass zwischen dem thermisch belasteten Körper (1) und den Wärmeverteilungskörpern (11,13) ein Spalt (18) verbleibt, der zum Zwecke der thermischen Kopplung von thermisch belastetem Körper und Wärmeverteilungskörpern bei gleichzeitiger mechanischer Entkopplung mit einem Fluid (17) ausgefüllt ist, **dadurch gekennzeichnet, daß** der fluidgefüllte Spalt (18) über eine Verbindung (8) mit einer Druckausgleichseinrichtung (19) verbunden ist, wobei die Druckausgleichseinrichtung (19) für einen Druckausgleich zwischen der äußeren Umgebung (9) und dem Koppelfluid (17) sorgt.

2. Vorrichtung nach Anspruch 1, **dadurch gekennzeichnet, dass** die Verbindung als Volumenausgleichskanal (8) ausgebildet ist.

3. Vorrichtung nach Anspruch 1, **dadurch gekennzeichnet, dass** die Wärmeverteilungskörper (11) massiv und aus einem Material hoher spezifischer thermischer Leitfähigkeit ausgeführt sind, wobei die spezifische thermische Leitfähigkeit wesentlich größer, insbesondere wenigstens zehnmal größer ist als die des Materials, aus dem der thermisch belastete Körper (1) besteht.

4. Vorrichtung nach Anspruch 1, **dadurch gekennzeichnet, dass** wenigstens einer der Wärmeverteilungskörper als Hohlkörper (13) ausgeführt ist, dessen inneres Volumen von einem Fluid (30) ausgefüllt ist, welches eine zirkulierende Strömungsbewegung vollzieht.

5. Vorrichtung nach Anspruch 1, **dadurch gekennzeichnet, dass** wenigstens einer der Wärmeverteilungskörper (11,13) über einen Trägerkörper (26) mit einer äußeren Tragstruktur (27) verbunden ist und von dieser gehaltert ist, während zwischen thermisch belasteten Körper (1) und Wärmeverteilungskörper (11,13) sowie zwischen thermisch belasteten Körper und Trägerkörper keine oder nur eine Verbindung sehr niedriger Steifigkeit (elastische Verbindung 28) besteht.

6. Vorrichtung nach Anspruch 1, **dadurch gekennzeichnet, dass** die Wärmeverteilungskörper (11,13) an innere Oberflächen (6) des thermisch belasteten Körpers (1) adaptiert sind.

7. Vorrichtung nach Anspruch 1, **dadurch gekennzeichnet, dass** der fluidgefüllte Spalt (18) über eine Verbindung (Verbindungskanal 24) mit einer verschließbaren Befüllungseinrichtung (21) verbunden ist.

8. Vorrichtung nach Anspruch 4, **dadurch gekennzeichnet, dass** zur Erzeugung der zirkulierenden Strömungsbewegung des Fluids (30), welches den als Hohlkörper (13) ausgeführten Wärmeverteilungskörper ausfüllt, eine Umwälzeinrichtung (29) an dafür vorgesehene Ein- und Auslassöffnungen (14,15) des Wärmeverteilungskörpers (11) angeschlossen ist.

9. Vorrichtung nach einem der Ansprüche 1 bis 8, **dadurch gekennzeichnet, dass** wenigstens ein Wärmeverteilungskörper (11) mit ein oder mehreren Wärmetauschelementen (32) einer Temperiereinrichtung (31) verbunden ist.

10. Vorrichtung nach Anspruch 9, **dadurch gekennzeichnet, dass** das Wärmetauschelement durch ein Peltierelement (32) gebildet ist, welches die absorbierte Nutzstrahlenergie und die beim Betrieb des Peltierelements (32) anfallende Verlustenergie in Form von Wärmestrahlung an die umgebende Struktur abgibt.

11. Vorrichtung nach Anspruch 8, **dadurch gekennzeichnet, dass** in dem Kreislauf (39) des strömenden Fluids (30) eine Einrichtung (31) zur Temperierung dieses Fluids eingebracht ist.

12. Vorrichtung nach Anspruch 1, **dadurch gekennzeichnet, dass** wenigstens einer der Wärmeverteilungskörper (11,13) mit einer Vielzahl thermisch gut leitfähiger fingerartiger, wenigstens annähernd senkrecht zur optischen Oberfläche ausgerichteter Fortsätze (16) versehen ist.

13. Vorrichtung nach Anspruch 12, **dadurch gekennzeichnet, dass** die Fortsätze (16) bis nahe an die optische Oberfläche heranreichen.

14. Projektionsobjektiv für die Halbleiter-Lithographie, mit wenigstens einem Spiegelträger, **dadurch gekennzeichnet, dass** wenigstens ein Spiegelträger mit einer Wärmeverteilungsvorrichtung nach den Ansprüchen 1 bis 12 versehen ist.

## Claims

1. A device for temperature compensation for thermally stressed bodies of materials of low specific heat conductivity, especially for supports carrying reflecting layers or substrates in the field of optics, such as for example in projection lens systems for semiconductor lithography, a heat distribution means with one or more heat distribution members (11, 13) being so adapted to surfaces (5, 6) of the thermally stressed body (1) that a gap (18) remains between the thermally stressed body (1) and the heat distribution members (11, 13), which gap (18) is filled with a fluid (17) for the purpose of thermal coupling of the thermally stressed body and the heat distribution members with simultaneous mechanical decoupling, **characterised in that** the fluid-filled gap (18) is connected via a connection (8) with a pressure compensating means (19), wherein the pressure compensating means (19) ensures pressure compensation between the external environment (9) and the coupling fluid (17).

2. A device according to claim 1, **characterised in that** the connection takes the form of a volume compensating duct (8).

3. A device according to claim 1, **characterised in that** the heat distribution members (11) are solid and made of a material of a high specific thermal conductivity, wherein the specific thermal conductivity is substantially greater, in particular at least ten times greater than that of the material of which the thermally stressed body (1) consists.

4. A device according to claim 1, **characterised in that** at least one of the heat distribution members takes the form of a hollow member (13), whose internal volume is filled by a fluid (30) which effects a circulating flow motion.

5. A device according to claim 1, **characterised in that** at least one of the heat distribution members (11, 13) is connected via a support member (26) to an external supporting structure (27) and is held thereby, while no connection or only a connection of very low rigidity (resilient connection 28) exists between thermally stressed body (1) and heat distribution member (11, 13) and between thermally stressed body and support member.

6. A device according to claim 1, **characterised in that** the heat distribution members (11, 13) are adapted to inner surfaces (6) of the thermally stressed body (1).

7. A device according to claim 1, **characterised in that** the fluid-filled gap (18) is connected with a closable filling means (21) via a connection (connection duct 24).

8. A device according to claim 4, **characterised in that**, to produce the circulating flow of the fluid (30), which fills the heat distribution member constructed in the form of a hollow member (13), a circulating means (29) is connected to in- and outlet openings (14, 15) provided therefor of the heat distribution member (11).

9. A device according to one of claims 1 to 8, **characterised in that** at least one heat distribution member (11) is connected to one or more heat exchange elements (32) of a temperature adjusting means (31).

10. A device according to claim 9, **characterised in that** the heat exchange element takes the form of a Peltier element (32), which outputs the absorbed useful beam energy and the lost energy arising during operation of the Peltier element (32) in the form of thermal radiation to the surrounding structure.

11. A device according to claim 8, **characterised in that** a means (31) for adjusting the temperature of the flowing fluid (30) is incorporated into the circuit (39) of said fluid.

12. A device according to claim 1, **characterised in that** at least one of the heat distribution members (11, 13) is provided with a plurality of finger-like extensions (16) 'oriented at least approximately perpendicularly to the optical surface and exhibiting good thermal conduction.

13. A device according to claim 12, **characterised in that** the extensions (16) extend to close to the optical surface.

14. A projection lens system for semiconductor lithography, having at least one mirror support, **characterised in that** at least one mirror support is provided with a heat distribution device according to claims 1 to 12.

## Revendications

1. Dispositif de compensation de température pour des corps chauffés constitués de matériaux à faible capacité thermique spécifique, notamment pour des supports de couches ou de substrats réfléchissants utilisés en optique, comme dans les objectifs de projection pour la lithographie de semi-conducteurs, dans lequel un dispositif de répartition de la chaleur, avec un ou plusieurs corps de répartition de la chaleur (11, 13), est adapté sur des surfaces (5, 6) du corps chauffé (1), de telle sorte que, entre le corps chauffé (1) et les corps de répartition de la chaleur (11, 13), subsiste un interstice (18) qui est rempli d'un fluide (17) pour le couplage thermique du corps chauffé et des corps de répartition de la chaleur avec, en même temps, un découplage mécanique, **caractérisé en ce que** l'interstice (18) rempli de fluide est relié avec un dispositif de compensation de pression (19) par l'intermédiaire d'une liaison (8), le dispositif de compensation de la pression (19) assurant une compensation de la pression entre l'environnement extérieur (9) et le fluide de couplage (17).

2. Dispositif selon la revendication 1, **caractérisé en ce que** la liaison est conçue comme un canal de compensation de volume (8).

3. Dispositif selon la revendication 1, **caractérisé en ce que** le corps de répartition de la chaleur (11) est réalisé de manière massive et dans un matériau à forte conductivité thermique spécifique, la conductivité thermique spécifique étant considérablement plus importante, notamment au moins dix fois plus importante que celle du matériau dont le corps chauffé (1) est constitué.

4. Dispositif selon la revendication 1, **caractérisé en ce que**, au moins un des corps de répartition de la chaleur est conçu comme un corps creux (13) dont le volume interne est rempli d'un fluide (30) qui effectue un mouvement d'écoulement circulant.

5. Dispositif selon la revendication 1, **caractérisé en ce que**, au moins un des corps de répartition de la chaleur (11, 13) est relié par l'intermédiaire d'un support (26) avec une structure de support externe (27) et est maintenu par celle-ci, tandis qu'entre les corps chauffés (1) et les corps de répartition de la chaleur (11, 13) ainsi qu'entre les corps chauffés et le corps de support il n'existe aucune liaison ou seulement une liaison de rigidité très faible (liaison élastique 28).

6. Dispositif selon la revendication 1, **caractérisé en ce que** les corps de répartition de la chaleur (11, 13) sont adaptés à des surfaces internes (6) du corps chauffé (1).

7. Dispositif selon la revendication 1, **caractérisé en ce que** l'interstice est rempli de fluide (18) par l'intermédiaire d'une liaison (canal de liaison 24) avec un dispositif de remplissage obturable (21).

8. Dispositif selon la revendication 4, **caractérisé en ce que**, pour produire le mouvement d'écoulement circulant du fluide (30) qui remplit le corps de répartition de la chaleur conçu comme un corps creux (13), un dispositif de circulation (29) est raccordé à des ouvertures d'entrée et de sortie (14, 15) du corps de répartition de la chaleur (11).

9. Dispositif selon l'une des revendications 1 à 8, **caractérisé en ce que**, au moins un corps de répartition de la chaleur (11) est relié à un ou plusieurs éléments d'échange de chaleur (32) d'un dispositif d'équilibrage de température (31).

10. Dispositif selon la revendication 9, **caractérisé en ce que** l'élément d'échange de chaleur est constitué d'un élément Peltier (32) qui restitue l'énergie de rayonnement utile absorbée et l'énergie perdue lors du fonctionnement de l'élément Peltier (32) sous la forme d'un rayonnement thermique à la structure environnante.

11. Dispositif selon la revendication 8, **caractérisé en ce que**, dans le circuit (39) du fluide circulant (30), se trouve un dispositif (31) d'équilibrage de la température de ce fluide.

12. Dispositif selon la revendication 1, **caractérisé en ce que**, au moins un des corps de répartition de la chaleur (11, 13) est muni d'une pluralité de prolongements (16) avec une bonne conductivité thermique, en forme de doigts, au moins approximativement perpendiculaires à la surface optique.

13. Dispositif selon la revendication 12, **caractérisé en ce que** les prolongements (16) arrivent à proximité de la surface optique.

14. Objectif de projection pour la lithographie de semi-conducteurs avec au moins un support de miroir, **caractérisé en ce que**, au moins un support de miroir est muni d'un dispositif de répartition de la chaleur selon les revendications 1 à 12.
